# EUROPEAN PATENT SPECIFICATION

(11) **EP 0 601 887 B1**
(45) Date of publication and mention of the grant of the patent: **10.07.1996**
(21) Application number: 93310002.6
(22) Date of filing: 10.12.1993
(51) Int. Cl.: G03F 7/20

(54) **Method for forming pattern**
Verfahren zur Herstellung eines Motivs
Méthode pour former un motif

(30) Priority: 10.12.1992 KR 9223805; 04.03.1993 KR 933210
(43) Date of publication of application: 15.06.1994
(73) Proprietor: SAMSUNG ELECTRONICS CO., LTD., Suwon-city, Kyungki-do 441-373 (KR)
(72) Inventor: Kim, Hak, Yangcheon-gu, Seoul (KR); Han, Woo-sung, Paldal-gu, Suwon-City, Kyungki-do (KR)
(74) Representative: Crawford, Fiona Merle

(56) References cited:
- DE-A- 1 622 341
- FR-A- 2 590 376
- GB-A- 1 548 017
- GB-A- 2 179 472
- GB-A- 2 247 535

## Description

The present invention relates to a method for forming a pattern, and more particularly, to a method for forming a pattern having a simple manufacturing process while providing a pattern in which a pattern profile at the portion of a high step is improved.

According to procession of high integration and high performance of a semiconductor device, a complicated structure has been introduced. Accordingly, technology enabling the formation of a fine pattern on a semiconductor substrate is much needed. It is widely known that such a pattern of a semiconductor device is formed by a photolithographic method.

The pattern forming method by the photolithographic method is as follows. First, a photoresist layer whose solubility may be changed on irradiation of light, such as, ultraviolet or X-ray, is formed on the upper surface of a substrate such as an insulation layer, a conductive layer or a semiconductor wafer, on which a pattern may be formed. Using a mask which is patterned so that a predetermined portion is selectively exposed to light, light is selectively irradiated onto the resist layer. Thereafter, by developing the resist layer to which the light is irradiated, a resist portion having a high solubility (in case of a positive resist, the exposed portion) is removed while a resist portion having a low solubility is left, so as to form a resist pattern. The portion of the substrate from which the resist is removed is etched to form a pattern. After completing a substrate etching, the remaining resist is removed to obtain a pattern necessary for the respective wiring, electrodes, etc.

Although a fine pattern can be formed in a high resolution using such a photolithography, a finer pattern formation needs further improvement of the related processes.

That is, in the fine pattern obtained after exposing the photoresist layer to the light and developing the exposed photoresist, the linewidth of the formed pattern is required to have the same ratio as the linewidth of a photomask pattern. However, since various procedural processes exist in photolithography, it is very difficult to maintain a constant linewidth of the pattern. Such linewidth deviations are due to an energy dosage difference which is collected in resists having different thicknesses, and due to light scattering at the step due to refraction and reflection (see "Silicon Processing for the VSLI Era" by S. Wolf and R.N. Tauber, Vol.1, p439, 1986).

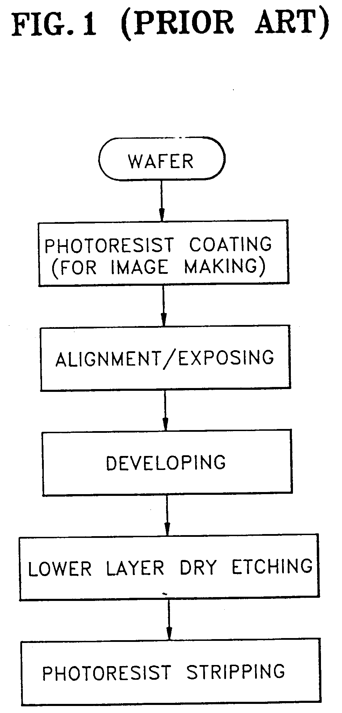

FIG. 1 of the accompanying drawings is a flowchart diagram of a pattern formation process according to the conventional single layer resist method. Referring to FIG. 1, the pattern formation will be described below in more detail.

The photosensitive material is coated on the upper surface of the substrate while the substrate is rotated at a velocity of 100 to 1,000rpm. Thereafter, if the substrate is rotated at a high speed, for example, 2,000 to 6,000rpm, the photosensitive material is radially spread by a centrifugal force and is formed as a resist layer having a uniform thickness on the whole substrate.

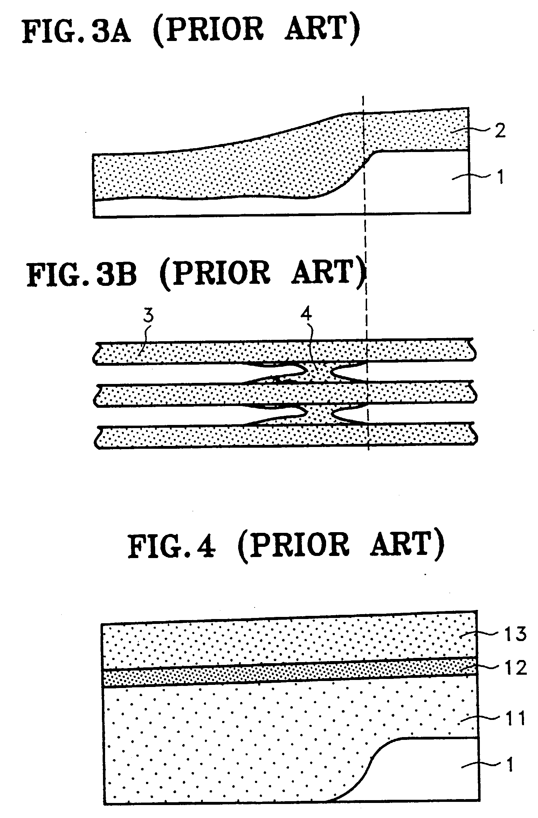

FIGs.3A and 3B of the accompanying drawings show a change of the resist thickness at the step during a pattern formation according to the conventional single layer resist method, and a shape of the pattern at the step after developing, respectively. As shown in FIGs.3A and 3B, since the pattern is already formed on the substrate, the thickness of the resist layer is partially varied in case of the existence of the step. That is, as shown in FIG.3A, resist layer 2 is thickly formed at the step portion of the upper portion of substrate 1. Particularly, the number of steps is increased due to the development of a complex structure according to the high integration of the device. If the resist of the step portion is formed more thickly than the other portion by such a complicated step during the photoresist coating, pattern bridge or scum, etc., is increasingly induced during the formation of the resist pattern.

FIG.3B shows a resist pattern 3 obtained by exposing and developing the resist layer formed as shown in FIG.3A. Referring to FIG.3B, the resist at the bottom of the step, that is, the portion corresponding to the portion at which the thickness of the resist is particularly thick, is not completely removed. Accordingly, it can be seen that the resist remains between resist patterns 3 and is designated as a reference numeral 4.

Such an undesirable phenomenon is caused due to the following circumstances. To form an excellent resist pattern, the focus of the light while performing the light exposure, should match the central line of the thickness of the resist. That is, since the exposure area at the surface of the resist is symmetrical to the light exposure area at the lower surface of the resist with respect to the focal point, when the focal point matches the central line of the thickness of the resist, the light exposure areas of the surface and the lower portion of the resist are identical to each other, thereby having a sharp distribution of the light intensity. However, since the thickness of the resist layer which is formed on the wafer having a step is not constant according to the area of the substrate, it is rarely possible to match the central line of the thickness of the whole resist layer with the focal point of the light. That is, for example, since the focal line of the light at the step having a relatively thick resist exists in the upper portion of the central line of the thickness of the resist, the lower exposure range of the resist becomes broader than the upper exposure range. This means that the exposure energy dosage at the lower portion of the resist is relatively short, that is, the exposure is not sufficient. The insufficient exposure generates undesirable variations in the linewidth, bridge, scum, etc. Accordingly, the resist pattern profile becomes poor, so that the substrate cannot be etched.

To solve the above problem according to the conventional single-layer resist (SLR) method, a multi-layer resist (MLR) method has been developed.

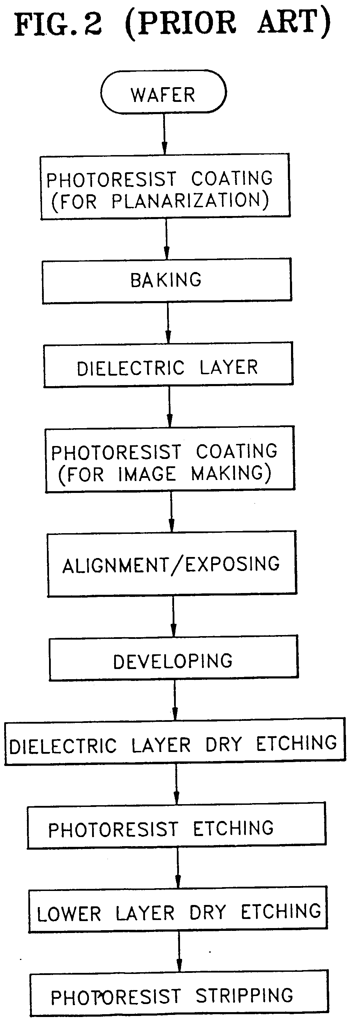

In FIG. 2 of the accompanying drawings a flowchart of the pattern formation process according to the MLR method is shown. FIG.4 shows an interlayer structure during a pattern formation according to the MLR method. Referring to FIGs.2 and 4, the MLR method will be described below in more detail.

First, on the upper portion of substrate 1, a lower photoresist 11 for planarization is more thickly coated than the step of the substrate, and is then baked. After interlayer insulation layer 12 is coated on the upper portion of the lower photoresist 11, an upper photoresist 13 for exposure is coated to form a multi-layer resist. After the upper photoresist is exposed and developed, the interlayer insulation layer is dry-etched. Thereafter, the lower planarization photoresist is dry-etched using oxygen gas (O₂) plasma to form a resist pattern. Then, using the resist pattern, the substrate is etched and the remaining resist is removed to obtain a pattern. The MLR method can yield patterns having high resolution less than or equal to 0.5µm.

One application of the MLR method is disclosed in Japanese Laid-open Patent Publication sho 51-107775. In the above Japanese publication, an organic layer (lower layer) is thickly coated on the upper portion of the substrate in which uneven portions or steps exist, so as to planarize the upper portion of the substrate. Then, an intermediate layer composed of a spin on glass (SOG), a phosphosilicate glass (PSG) or SiO₂ is formed on the upper portion of the substrate. Then, a photoresist layer (upper layer) is formed on the upper portion of the intermediate layer. Then, according to the conventional photolithographic technology, the upper layer is exposed and developed, and the intermediate layer is etched thereby to work the intermediate layer into a predetermined shape. Then, using the intermediate layer as a mask, the exposed portion of the thick lower layer is dry-etched for removal. Thereafter, the exposed portion of the layer to be worked is dry-etched by the lower layer patterning thereby to form a predetermined pattern.

Also, Korean Patent Publication No. 89-3903 discloses a method for improving a resolution of a pattern in the MLR method. For doing this, by reducing differences between the refractive index of the intermediate layer with respect to the light and the refractive index of the upper layer and the lower layer with respect to the light, the light reflection is reduced in each interface between the upper layer and the intermediate layer, and the intermediate layer and the lower layer. At the same time, interference in the layer which is caused by the difference of the layer thickness in the lower layer is prevented and variation of the dimension is suppressed during the pattern formation. The method described in the above-mentioned Korean patent publication comprises the steps of sequentially depositing a layer to be worked, a lower layer composed of an organic polymer compound, an intermediate layer made of a material having a larger dry-etching resistant property than the lower layer and a photosensitive upper layer on a substrate, forming a pattern of the upper layer having a predetermined shape by selectively exposing light onto a predetermined portion of the upper layer and developing the exposed portion, removing an exposed portion of the lower layer, and forming a substrate pattern by removing the exposed portion of the substrate, wherein the difference between the light refractive index of the intermediate layer with the light refractive index of the upper layer and the lower layer are less than or equal to 12%.

A fine pattern having a high resolution can be obtained by the MLR method. However, since the processes are complicated and should pass through various steps, productivity is low, the number of defective products increases and the entire cost of the semiconductor manufacturing process increases.

Therefore, it is an object of the present invention to provide a pattern formation method capable of obtaining a pattern having an excellent resolution, in which since a single-layer resist method is used, complicated processes are not passed through as in a multi-layer resist method, thereby simplifying processes, saving cost, and easily developing the photoresist which becomes thick at the step portion.

According to the present invention, there is provided a method for forming a pattern comprising the steps of:
forming a photoresist layer to form a pattern by photolithography on a substrate having a step;
firstly exposing said photoresist layer using a predetermined first mask;
secondly exposing a portion of said photoresist layer which is relatively thick due to said step using a predetermined second mask, said second mask having a grating pattern or a checkerboard pattern; and
developing the exposed photoresist layer.

Embodiments of the present invention will now be described, by way of example, with reference to the accompanying drawings, in which:
FIG.1 is a flowchart of a pattern formation process according to the conventional single-layer resist (SLR) method;
FIG.2 is a flowchart of a pattern formation process according to the conventional multi-layer resist (MLR) method;
FIGs.3A and 3B show a change of the resist thickness at the step during a pattern formation according to the conventional single layer resist method, and a shape of the pattern at the step after developing, respectively;
FIG.4 is a cross-sectional view of the interlayer structure during a pattern formation according to the conventional MLR method;
FIG.5 is a flowchart of a pattern formation process according to an embodiment of the present invention;
FIG.6A is a cross-sectional view of a photoresist layer having a step;
FIGs.6B and 6C show layouts of arranging grating patterns which are designed on a second mask used in an embodiment of the present invention on the upper portion of the photoresist layer of FIG.6A;
FIG.6D shows a layout of arranging a checkered pattern which is designed on a second mask used in an embodiment of the present invention on the upper portion of the photoresist layer of FIG.6A;
FIGs.7A to 7C show a procedure of the pattern formation according to the process flow in the pattern formation method according to an embodiment of the present invention; and
FIGs.8A and 8B show cross-section of the resist at the step during a pattern formation according to the conventional single layer resist method, and a shape of the pattern at the step after developing, respectively.

In a preferred embodiment of the present invention, a resist is exposed, and then thicker resist portions are again exposed using a second mask. It is particularly desirable that the resist layer is sequentially exposed in a exposure apparatus using a first mask and the second mask. Also, it is desirable that the second mask pattern is manufactured so as to have a size of 0.5µm to 400µm along a step portion. More preferably, the second mask pattern is manufactured so as to adjust the size of the second mask pattern according to the thickness of the photoresist and the depth of the step. That is to say, light passing through the second mask is differentially attenuated according to the thickness of the photoresist and the depth of the step.

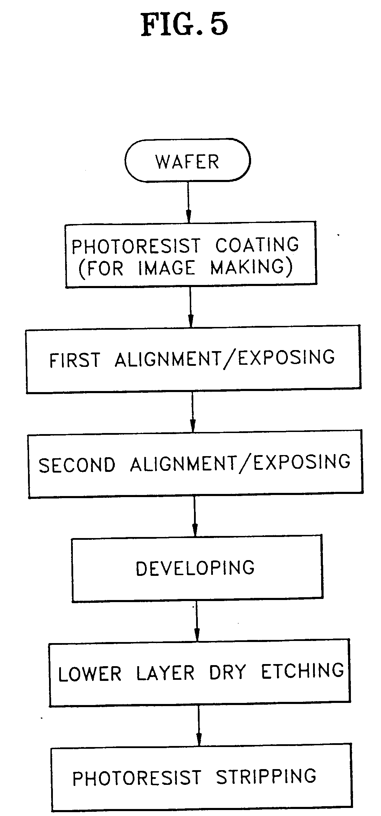

FIG.5 is a flowchart of a pattern formation process according to an embodiment of the present invention. To form a pattern having a high resolution in a device having a step in the present invention, a first exposure is performed on a single-layer resist using a mask having a predetermined pattern. Then, to remove effectively the thick resist at the step portion, a second exposure is performed using a second mask having a predetermined pattern. That is, to solve the problem that since a decomposition density of a photo active compound (PAC) is small due to a weak exposure energy dosage at the thick resist portion after the first exposure, the thick resist portion is not cleanly developed, the step portion is once more exposed, thereby supplementing the exposure energy dosage to increase the decomposition density of the PAC.

It is desirable that the exposure energy dosage of the second exposure is 5% to 20% that of the first exposure. If the energy dosage is less than 5%, the exposure effect is weak, while if the energy dosage is more than 20%, the increase in the resolution of the pattern according to the energy increase is rather reduced. If the second exposure energy dosage is made to be weaker than that of the first exposure energy dosage, even though the portion which is not exposed during insertion of the first mask is exposed during insertion of the second mask, that portion is not left as a pattern since it has a small exposed light quantity and is not developed. Since the resist is sufficiently exposed at the step portion which is twice exposed, a clean pattern is formed even in an exposed edge portion.

Particularly, since the second mask has a pattern matching the upper portion of the thick resist layer of the step, the second mask has few fine patterns as in the first mask. Since the second mask has a sufficiently large size, the second exposure does not require exact arrangement of the mask as in the first exposure. Also, there are no problems with rotation, orthogonality, etc., of the mask. Thus, according to the method of the present invention, the second exposure process is additionally added. However, it can be seen that when compared with the conventional exposure process, the second exposure process is relatively simple, but the effect thereof is excellent.

To form a more excellent pattern, it is preferred that a defocus of several micrometers or so is given during the second exposure using the second mask. Such a defocus improves resolution of the pattern at the edge portion of the resist in which the first mask is overlapped with the second mask. Preferably, the defocus is 0.5 to 20µm.

Also, in the pattern formation method according to an embodiment of the present invention, a grating pattern (X- or Y-direction) or a checkered pattern is additionally added in the second mask in the predetermined second pattern, to perform the second exposure.

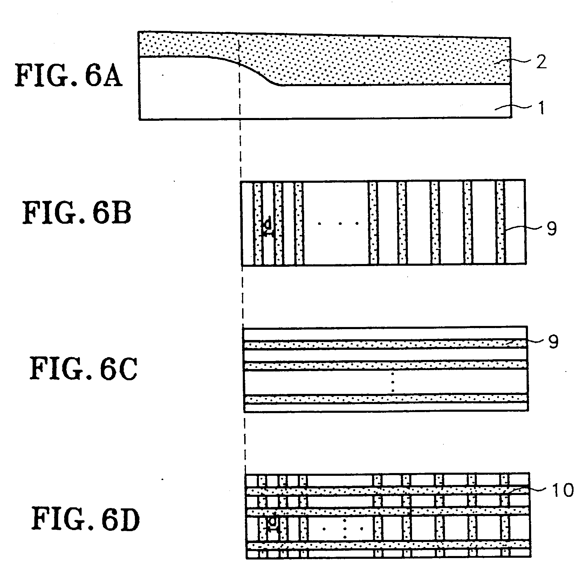

FIGs.6A to 6D show that grating patterns (reference numeral 9 in FIGs.6B and 6C) or a checkered pattern (reference numeral 10 in FIG.6D) which is designed on the second mask is arranged on the upper portion of photoresist layer 2 having a step (FIG.6A).

In such a pattern, the distance "d" between the gratings which are inserted parallel to the step is properly adjusted and arranged according to the change of the thickness of the photoresist by the step. Accordingly, the variation of the pattern size according to the change of the thickness of the photoresist can be minimized. Here, the size or the distance of the grating pattern or the checkered pattern which is inserted into the second mask having a predetermined pattern is made to be equal to or less than the resolution critical peripheral area. It is desirable that the second pattern is designed as a pattern which is not represented by the defocus. It is preferred that the grating pattern or the checkered pattern can be varied in the size or the distance thereof according to the change of the thickness of the photoresist.

The mask is generally classified as a hard mask or a soft mask. However, since the soft mask has the difficulty in forming a fine pattern less than or equal to 2.5µm, the hard mask is chiefly used in the recent semiconductor manufacturing field. The hard mask is manufactured by coating a photointerceptive thin layer material on the substrate by means of deposition, sputtering or chemical vapor deposition. Sodalime, borosilicate or crystal, etc., can be used as the material of the mask substrate. Among them, the price of the crystal is particularly high. However, the crystal has merits in that the thermal expansion coefficient is extremely small and the transmission rate of the shallow ultraviolet or deep ultraviolet light is very high. Thus, in embodiments of the present invention, it is desirable that the crystal is used as a material of the mask substrate.

Silicon, ferric oxide, chrome or oxides of chrome can be used as a photointerceptive thin layer material which is coated on the mask. Particularly, it is desirable that a composite material of chrome and chromic oxide is used in embodiments of the present invention.

Besides the conventional mask in which chrome/chromic oxide is coated on the substrate, a reflective mask or a phase shift mask, etc., can be used as a mask which can be used in embodiments of the present invention.

The exposure light which can be used in the present invention has no limitations as far as the pattern can be formed by giving difference of solubility between the exposed portion and the non-exposure portion of the photoresist. As the light, a KrF Excimer laser (248nm) and ArF Excimer laser (193nm) as well as the g-line (436nm), i-line (365nm), h-line (405nm) and broadband deep ultraviolet light (240-440nm) coming from a mercury lamp or a Xe lamp, can be used in the present invention.

Besides a reduced projection exposure method, one to one projection exposure method, X-ray exposure method, etc., can be used without any exception as an exposure method.

The photosensitive material is generally classified into a positive type or a negative type. The negative type photosensitive material is composed of a mixture of cyclized rubber-based resin and bisazide-based compound. The light irradiated portion is hardened by forming a network structure by means of a crosslinked material (bisazide-based compound), and the non-exposed portion is dissolved out by a developer. By contrast, the positive type photosensitive material is generally composed of a quinone diazide-based photosensitive material, an alkaline-soluble phenol-based resin and an organic solvent. The resin is itself alkaline-insoluble, and is changed into alkaline-soluble by the light irradiation. Since the positive type photosensitive material has higher resolution than that the negative type, the positive type is widely used recently.

In the present invention, either the positive type or the negative type can be used as the photosensitive material. However, as described above, it is desirable that the positive type having a higher resolution is used. As the positive type photosensitive material, used in the present invention, novolak-based resist composition, chemically amplified resist composition or chain scission resist composition can be used in the present invention.

Hereinbelow, the preferred embodiments of the present invention will be specifically described. However, the present invention is not limited thereto.

### Example 1

By spin-coating the photoresist including novolak-based resin and diazonaphthoquinon on the upper portion of the substrate having a step, the photoresist layer is formed in a thickness of 1.2µm. Alignment-exposure using a predetermined crystal mask having a metal pattern is performed with the ultraviolet g-line (436nm). Thereafter, to remove the thick resist at the step portion effectively, a second mask is inserted in which a pattern designed to have a size of 9 to 10µm or so in the same direction as that of the metal pattern. Then, the firstly exposed resist is secondly exposed sequentially at the step with energy of 10% or so of the first exposure energy. Here, the focal point of the second mask is made to move by about 5µm as a defocus, thereby to perform the exposure. Thereafter, wet development is performed with an aqueous alkaline solution of tetramethylammonium hydroxide (TMAH), to form a resist pattern. Using the formed resist pattern, the substrate to be worked is etched, and the remaining resist is removed, thereby obtaining a desired pattern.

### Example 2

The photoresist layer is formed on the upper portion of the substrate having a step, by the same method as described in example 1. Alignment-exposure using a predetermined crystal mask having a metal pattern is performed with the ultraviolet g-line (436nm). Thereafter, to remove effectively the thick resist at the step portion, a second mask is inserted in which a pattern designed to have a size of 9 to 10µm or so in the same direction as that of the metal pattern and a grating pattern or a checkered pattern having a size of 0.1 to 0.2µm is aligned therein. Then, the firstly exposed resist is alignment-exposed (secondly exposed) sequentially at the step with the energy of 10% or so of the first exposure energy. Here, the focal point of the second mask is made to move by about 5 µm as a defocus, thereby to perform exposure. Thereafter, wet development is performed with an aquous alkaline solution of tetramethylammonium hydroxide (TMAH), to form a resist pattern. Using the formed resist pattern, the substrate to be worked is etched, and the remaining resist is removed, thereby obtaining a desired pattern.

In the above embodiments, roughness of the pattern at the edge portion can be improved in which the first mask and the second mask are overlapped by the defocus, and the effect of the grating pattern or the checkered pattern can be improved.

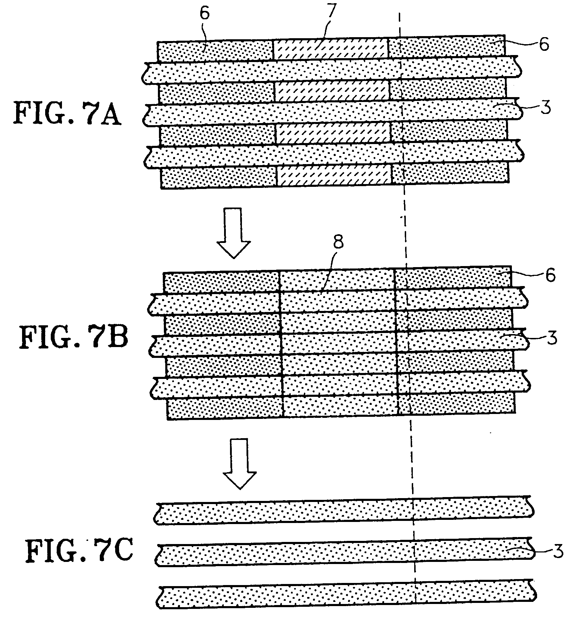

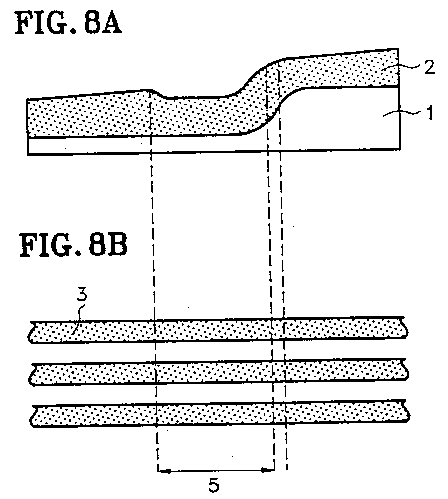

FIGs.7A to 7C show a procedure of the pattern formation according to the process flow in the pattern formation method according to the present invention. FIGs.8A and 8B show shapes of the patterns at the step, which are obtained according to the first embodiment and the second embodiment.

The above embodiments will be described below in more detail with reference to FIGs.7A through 7C and FIGs.8A and 8B.

As shown in FIGs.7A to 7C, the resist is firstly exposed (FIG.7A). Among the firstly exposed resists, resist 6 at the top of the step is not exposed but resist 7 at the bottom of the step is secondly exposed (FIG.7B), to obtain the twice exposed resist 8. Then, by a post-exposure bake (PEB) and development, a smooth resist pattern 3 is formed without bridging or the scum at the portion of the step (FIG.7C).

As shown in FIGs.8A and 8B, the obtained resist pattern (FIG.8B) is represented in correspondence to the resist (FIG.8A) at the portion of the step. From FIGs.8A and 8B, it can be seen that a clean pattern is formed over the whole areas including area 5 at the bottom of the step where defects are apt to be present.

As described above, if the fine pattern is made to be formed according to the present invention, the resist pattern having an excellent profile which can be formed by the MLR method can be obtained with only the single-layer resist. This can be simply accomplished by performing exposure twice using two mask patterns.

Also, the present invention, the defect rate is extremely small (excluding the defects of the photoresist itself), and the process is simple, thereby obtaining effects of through-put improvement and cost savings. Thus, even though the step exists, the fine pattern can be easily formed.

## Claims

1. A method for forming a pattern comprising the steps of:
forming a photoresist layer to form a pattern by photolithography on a substrate (1) having a step;
firstly exposing said photoresist layer using a predetermined first mask;
secondly exposing a portion of said photoresist layer which is relatively thick due to said step using a predetermined second mask, said second mask having a grating pattern or a checkerboard pattern; and
developing the exposed photoresist layer.

2. A method according to claim 1, wherein a dimension of the pattern of said second mask is adjusted so as to attenuate differentially light passing through said second mask in relation to the thickness of the photoresist and the depth of said step.

3. A method according to claim 1 or 2, wherein said photoresist layer is sequentially exposed in an exposure apparatus using said first and second masks.

4. A method according to any preceding claim, wherein exposure energy during said second exposing step is 5 to 20% that of said first exposing step.

5. A method according to any preceding claim, wherein a defocus is given during said second exposing step.

6. A method according to any preceding claim, wherein said defocus is 0.5 to 20µm.

7. A method according to any preceding claim, wherein said grating pattern or said checkerboard type pattern is varied in size or distance according to variation of the photoresist thickness.

8. A method according to any preceding claim, wherein said grating pattern or said checkerboard type pattern has a size not more than a critical resolution

9. A method according to any one of claims 1 to 8, wherein said grating pattern or said checkerboard type pattern is a pattern having not more than a critical resolution by a defocus at said second exposing step.

## Patentansprüche

1. Verfahren zur Herstellung eines Motivs umfassend die Schritte:
Ausbildung einer Photoresistschicht zum Herstellen eines Motivs durch Photolithographie auf einem Substrat (1) mit einer Stufe;
erstens Belichten der Photoresistschicht unter Verwendung einer bestimmten ersten Maske;
zweitens Belichten eines Teils der Photoresistschicht, die bedingt durch die Stufe relativ dick ist, unter Verwendung einer bestimmten zweiten Maske, wobei die zweite Maske ein Gittermuster oder ein Schachbrettmuster aufweist; und
Entwickeln der belichteten Photoresistschicht.

2. Verfahren nach Anspruch 1, worin eine Dimension des Motivs der zweiten Maske so angepaßt ist, daß durch die zweite Maske hindurchtretendes Licht in Relation zur Dicke des Photoresists und der Tiefe der Stufe differentiell absorbiert wird.

3. Verfahren nach Anspruch 1 oder 2, worin die Photoresistschicht in einem Belichtungsapparat unter Verwendung der ersten und der zweiten Maske sequentiell belichtet wird.

4. Verfahren nach einem der vorhergehenden Ansprüche, worin die Belichtungsenergie während des zweiten Belichtungsschritts 5 bis 20 % der des ersten Belichtungsschritts beträgt.

5. Verfahren nach einem der vorhergehenden Ansprüche, worin während des zweiten Belichtungsschritts eine Defokussierung gegeben wird.

6. Verfahren nach einem der vorhergehenden Ansprüche, worin die Defokussierung 0,5 bis 20 µm beträgt.

7. Verfahren nach einem der vorhergehenden Ansprüche, worin das Gittermuster oder das schachbrettartige Muster in der Größe oder im Abstand gemäß einer Änderung der Dicke des Photoresists variiert werden.

8. Verfahren nach einem der vorhergehenden Ansprüche, worin das Gittermuster oder das schachbrettartige Muster eine Größe von nicht mehr als einer kritischen Auflösung besitzt.

9. Verfahren nach einem der Ansprüche 1 bis 8, worin das Gittermuster oder das schachbrettartige Muster durch eine Defokussierung im zweiten Belichtungsschritt ein Muster mit nicht mehr als einer kritischen Auflösung darstellt.

## Revendications

1. Méthode pour former un motif, comprenant les phases de :
formation d'une couche de produit photorésistant pour former un motif par photolithographie sur un substrat (1), ayant une phase ;
d'exposition, tout d'abord, de ladite couche de produit photorésistant en utilisant un premier masque déterminé préalablement,
d'exposition, ensuite, d'une partie de ladite couche de produit photorésistant qui est relativement épaisse du fait de ladite phase, en utilisant un second masque déterminé préalablement, ledit second masque présentant un motif en réseau ou un motif à damiers ; et
développement de la couche de produit photorésistant exposée.

2. Méthode selon la revendication 1, dans lequel une dimension du motif dudit second masque est réglée de façon à atténuer, de façon différentielle, la lumière traversant ledit second masque, par rapport à l'épaisseur du produit photorésistant et à l'intensité de ladite phase.

3. Méthode selon la revendication 1 ou la revendication 2, dans lequel ladite couche de produit photorésistant est exposée de façon séquentielle dans un appareil d'exposition utilisant lesdits premier et second masques.

4. Méthode selon l'une quelconque des revendications précédentes, dans lequel l'énergie d'exposition pendant ladite seconde phase d'exposition représente 5 à 20% de celle de ladite première phase d'exposition.

5. Méthode selon l'une quelconque des revendications précédentes, dans lequel une déconcentration est effectuée pendant ladite seconde phase d'exposition.

6. Méthode selon l'une quelconque des revendications précédentes, dans lequel ladite déconcentration est de 0,5 à 20 m.

7. Méthode selon l'une quelconque des revendications précédentes, dans lequel ledit motif en réseau ou ledit motif de type à damiers est modifié en dimension ou en distance en fonction de la variation de l'épaisseur du produit photorésistant.

8. Méthode selon l'une quelconque des revendications précédentes, dans lequel ledit motif en réseau ou ledit motif de type à damiers a une dimension qui n'est pas supérieure à une résolution critique.

9. Méthode selon l'une quelconque des revendications 1 à 8, dans lequel ledit motif en réseau ou ledit motif de type à damiers est un motif n'ayant pas plus d'une résolution critique lors d'une déconcentration à ladite seconde phase d'exposition.
